# EUROPEAN PATENT APPLICATION

(11) **EP 3 070 482 A1**
(43) Date of publication of application: **21.09.2016**
(21) Application number: 14860980.3
(22) Date of filing: 10.11.2014
(51) Int. Cl.: G01R 21/00

(54) **ELECTRONIC DEVICE AND METHOD FOR DETECTING EXTERNAL DEVICE FROM ELECTRONIC DEVICE**

(30) Priority: 11.11.2013 KR 20130136133
(71) Applicant: Samsung Electronics Co., Ltd., Suwon-si, Gyeonggi-do 443-742 (KR)
(72) Inventor: PARK, Youngjin, Bucheon-si Gyeonggi-do 422-756 (KR)
(74) Representative: Birchenough, Lewis
(86) International application number: PCT/KR2014/010739
(87) International publication number: WO 2015/069077

(57) **Abstract**

An electronic device performs a method for detecting an external device by using an electric power pattern of the external device. In the method, the electronic device collects power information of the external device, and extracts power pattern information from the collected power information. Additionally, the electronic device compares the extracted power pattern information with previously stored power pattern information, and identifies a type of the external device, based on a comparison result.

## Description

### [Technical Field]

The present invention relates to a method for detecting an external device by using an electric power pattern at an electronic device and to the electronic device using the method.

### [Background Art]

Recently various attempts to reduce energy consumption have been made. For such a reduction in energy consumption, an electronic device such as a smart plug is used widely. The smart plug is located between a plug socket and an external device, measures usage power of the external device, and sends this information to a user or an energy management device. That is, receiving information about power consumption of each external device through the smart plug, the user or the energy management device can determine an energy saving guideline.

### [Disclosure of Invention]

### [Technical Problem]

Hereinafter, various embodiments will be described with reference to the accompanying drawings. In the drawings, the same or similar reference numerals denote corresponding features consistently. Additionally, well known functions and configurations may not be described or illustrated in detail to avoid obscuring the subject matter of the present invention. The present invention may be embodied in many different forms without changing technical subject matters and essential features as will be understood by those skilled in the art. Therefore, embodiments set forth herein are exemplary only and not to be construed as a limitation.

Unfortunately, a conventional electronic device such as a smart plug simply measures power consumption and then provides it to the user or the energy management device, or determines an external device in an inaccurate manner and then provides it to the user or the energy management device.

The smart plug that simply measures power consumption and provides it to the user or the energy management device fails to identify the type of an external device that operates in conjunction with the smart plug. Therefore, the user suffers inconvenience of having to register the type of such an external device.

The smart plug that determines an external device in an inaccurate manner and provides it to the user or the energy management device determines the type of the external device by using a current wave observed when the external device operates. This approach invites a problem of having to observe a current wave of each external device and continuously manage it with database.

The present invention provides a method for detecting an external device by using a power consumption pattern of the external device and also provides an electronic device using this method.

### [Solution to Problem]

A method for detecting an external device at an electronic device according to an embodiment of the present invention includes steps of collecting power information of the external device; extracting power pattern information from the collected power information; comparing the extracted power pattern information with previously stored power pattern information; and identifying a type of the external device, based on a comparison result.

A method for detecting an external device at an electronic device according to an embodiment of the present invention includes steps of collecting power information, contextual information, and location information about at least one of the external device; extracting power pattern information from the collected power information; comparing the extracted power pattern information with previously stored power pattern information; comparing the collected contextual information with previously stored contextual information; and identifying a type of the external device, based on a comparison result of the power pattern information, a comparison result of the contextual information, and the location information.

An electronic device connected to an external device according to an embodiment of the present invention includes a communication unit connected to other electronic device by means of communication; a current-voltage measuring unit configured to collect power information of the external device; and a control unit configured to extract power pattern information from the collected power information, to compare the extracted power pattern information with previously stored power pattern information, and to identify a type of the external device, based on a comparison result.

### [Advantageous Effects of Invention]

The electronic device and the external device detection method thereof according to the present invention can detect an external device exactly and automatically by using a power consumption pattern of the external device and then offer a detection result to a user or an energy management device.

### [Brief Description of Drawings]

FIG. 1 is a diagram illustrating a method for transmitting power consumption information of an external device from an electronic device to other electronic device according to an embodiment of the present invention.
FIG. 2 is a block diagram illustrating an electronic device according to an embodiment of the present invention.
FIG. 3 is a flow diagram illustrating an external device detection method of an electronic device according to an embodiment of the present invention.
FIG. 4 is a flow diagram illustrating an external device detection method of an electronic device according to an embodiment of the present invention.
FIG. 5 is a diagram illustrating power pattern information according to an embodiment of the present invention.
FIG. 6 is a diagram illustrating an external device detection method based on location information according to an embodiment of the present invention.

### [Mode for the Invention]

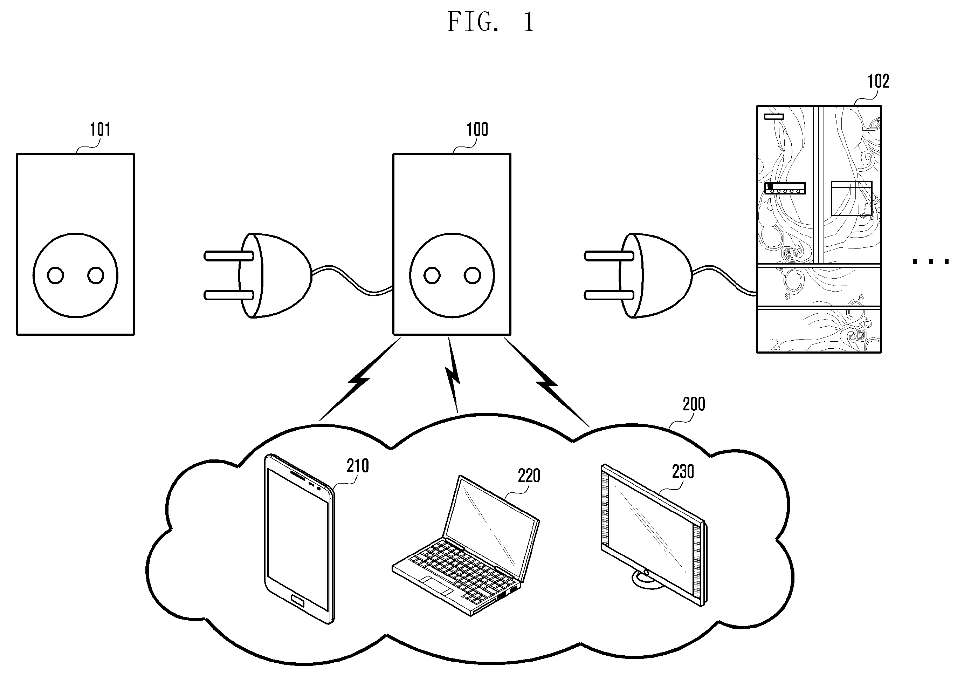

FIG. 1 is a diagram illustrating a method for transmitting power consumption information of an external device 102 from an electronic device 100 to other electronic device 200 according to an embodiment of the present invention.

The electronic device 100 according to an embodiment of this invention may be connected between an external socket 101 for supplying electric power and the external device 102. The external device 102 may be a device capable of receiving electric power through the external socket 101 or the electronic device 100. For example, the external device 102 may be home appliances such as a refrigerator, a TV, a microwave oven, an electric iron, a vacuum cleaner, a washing machine, an air conditioner, an audio device, a coffeepot, a toaster, a cooktop, a dryer, an electric heater, an electric cooker, a dishwasher, and PC.

The electronic device 100 may include a plug for connection with the external socket 101 and a socket for connection with the external device 102. The electronic device 100 is connected between the external socket 101 for supplying electric power and the external device 102 for receiving electric power, and transmits energy usage information of the external device 102 to the other electronic device 200.

The electronic device 100 may collect power consumption information of the external device 102, determine the type of the external device 102 on the basis of a power consumption pattern of the external device 102, and transmit such information to the other electronic device 200. In order to transmit the collected power consumption information of the external device 102 and information about the determined type of the external device 102, the electronic device 100 may be connected to the other electronic device 200 by means of communication. The electronic device 100 connected to the other electronic device 200 may control power consumption of the external device 102 under the control of the other electronic device 200.

The other electronic device 200 may be an energy management device. The other electronic device 200 may receive, from the electronic device 100, the power consumption information of the external device 102 and information about the type of the external device 102. The other electronic device 200 allows a user to check power consumption information based on the type of the external device 102. The user who checks the power consumption information based on the type of the external device 102 through the other electronic device 200 may control power consumption of the external device 102 through the other electronic device 200. The other electronic device 200 may include a communication unit (not shown) for receiving the power consumption information of the external device 102 and the information about the type of the external device 102, a display unit (not shown) for offering the power consumption information based on the type of the external device 102 to the user, a control unit (not shown) for controlling power consumption of the external device 102 in response to a user input, and a user input unit (not shown) for receiving the user input. For example, the communication unit (not shown) of the other electronic device 200 may be connected to the electronic device 100 by using wired/wireless communication technology. The display unit (not shown) of the other electronic device 200 may perform a function to display an image or data to the user. The display unit (not shown) of the other electronic device 200 may include a display panel. The display panel may use, for example, an LCD (Liquid Crystal Display), an AMOLED (Active Matrix Organic Light Emitting Diode), and the like. The display unit (not shown) of the other electronic device 200 may further include a controller for controlling the display panel. The display panel may be implemented, for example, in a flexible, transparent, or wearable form. The display unit (not shown) of the other electronic device 200 may be offered in a touch screen form by being combined with a touch panel. For example, the touch screen may include an integrated module in which the display panel and the touch panel are combined as a stack structure. The user input unit (not shown) of the other electronic device 200 may receive various commands from the user. The user input unit (not shown) of the other electronic device 200 may include at least one of a touch panel, a pen sensor, and a key.

In an embodiment, the other electronic device 200 may be a PC (Personal Computer), a smart phone, a tablet PC, a PMP (Portable Multimedia Player), a PDA (Personal Digital Assistant), a laptop PC, and a wearable device, each of which may include the communication unit (not shown), the display unit (not shown), the control unit (not shown), and the user input unit (not shown).

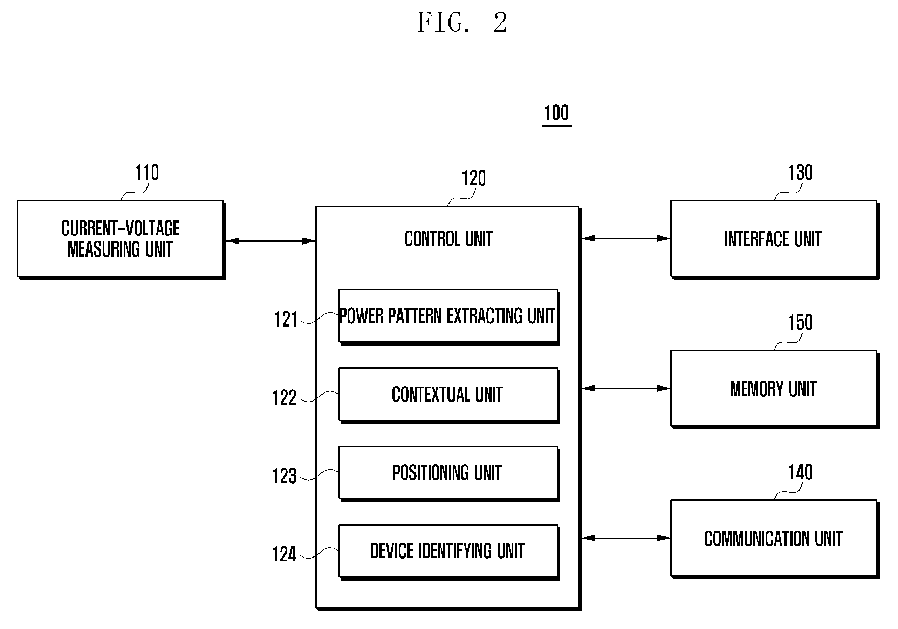

FIG. 2 is a block diagram illustrating an electronic device 100 according to an embodiment of the present invention.

The electronic device 100 may include a current-voltage measuring unit 110, a control unit 120, an interface unit 130, a communication unit 140, and a memory unit 150.

The current-voltage measuring unit 110 may measure an electric current and voltage of the external device 102 so as to measure power consumption of the external device 102. The current-voltage measuring unit 110 may monitor variations in current and voltage of the external device 102, calculate power consumption of the external device 102 by using measured current and voltage values, and transmit a calculation result to the control unit 120. The current-voltage measuring unit 110 may include at least one of an ammeter, a voltmeter, and a wattmeter so as to measure a current, voltage, and/or power of the external device 102. The wattmeter contained in the current-voltage measuring unit 110 may measure power information, such as consumed power, power factor, effective power, or reactive power, about at least one external device 102. The current-voltage measuring unit 110 may transmit the measured power information about the external device 102 to the control unit 120.

The control unit 120 may detect the type of the external device 102 and also detect power consumption of the external device 102. The detected type and power consumption of the external device 102 may be transmitted to the interface unit 130 or the communication unit 140. The interface unit 130 may display the type and power consumption of the external device 102 detected by the control unit 120. For example, the interface unit 130 may include a display for displaying the detected external device 102. The communication unit 140 may transmit, to the other electronic device 200, information about the detected type and power consumption of the external device 102.

A power pattern extracting unit 121 may extract a power pattern of the external device 102 by using power information about the external device 102 received from the current-voltage measuring unit 110. For example, the external device 102 may be one of a refrigerator, a TV, a microwave oven, an electric iron, a vacuum cleaner, a washing machine, an air conditioner, an audio device, a coffeepot, a toaster, a cooktop, a dryer, an electric heater, an electric cooker, a dishwasher, and PC. Such external devices 102 may have different patterns in power consumption.

Depending on internal components and operation characteristics defined in design, the external device 102 may have a specific power pattern in power consumption.

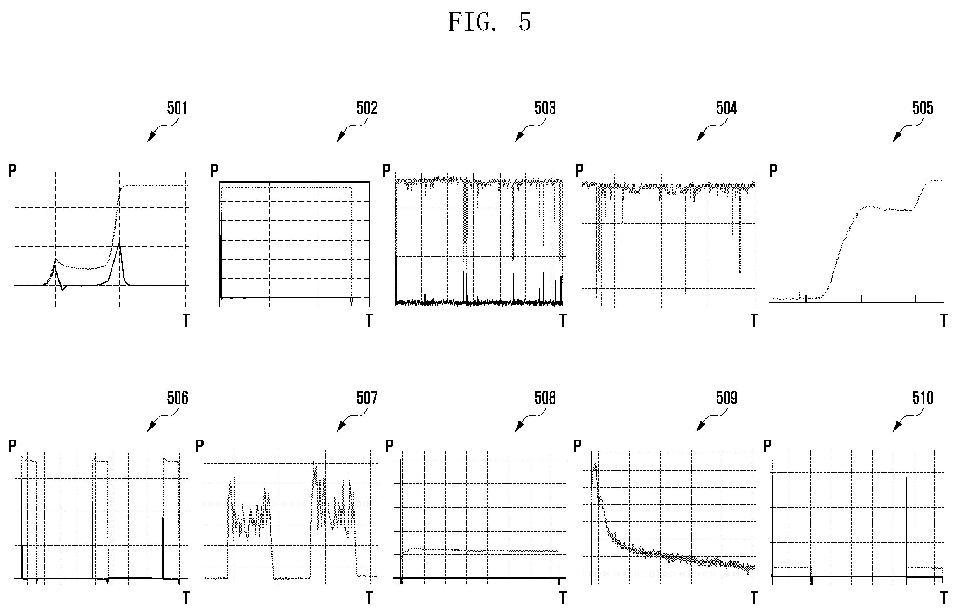

FIG. 5 is a diagram illustrating power pattern information according to an embodiment of the present invention. Referring to FIGS. 2 and 5, a power consumption pattern of the external device 102 is as follows.

As indicated by a reference numeral 501, the external device 102 such as a microwave oven has a power consumption pattern of a 2-stage turn-on type from low power consumption to high power consumption so as to uniformly apply heat to food, for example, so as to heat food after thaw. Specifically, the power consumption pattern of a 2-stage turn-on type includes an increase of effective power in the off-state, a flat form for a certain time, a further increase of effective power, and a further flat form.

As indicated by a reference numeral 502, the external device 102, such as a coffeepot or a toaster, which cooks food or heats liquid for a short time, the external device 102, such as an electric heater, which provides heat for a certain time, or the external device 102, such as a vacuum cleaner, which has load for a certain time, has a power consumption pattern of a flat form for a certain time.

As indicated by a reference numeral 503, the external device 102, such as a refrigerator or a vacuum cleaner, which uses a small motor, or the external device 102, such as a TV, which uses a light source, has a power consumption pattern of a small-scale vibration form.

As indicated by a reference numeral 504, the external device 102, such as a TV, which performs a screen switch or channel change, has a power consumption pattern of a negative spike form in which effective power consumption is reduced only for a short time at the screen switch or channel change.

As indicated by a reference numeral 505, the external device 102, such as an air conditioner, which gradually regulates an indoor temperature and humidity, has a power consumption pattern of a gradual rising form of power consumption.

As indicated by a reference numeral 506, the external device 102, such as an electric iron or a cooktop, which should maintain a uniform temperature without overheating, has a power consumption pattern of a pulse train form.

As indicated by a reference numeral 507, the external device 102, such as a washing machine, which uses a large motor and causes an increase or reduction in power consumption depending on inertia of laundry, has a power consumption pattern of a large-scale vibration form.

As indicated by a reference numeral 508, the external device 102 which uses a motor has a power consumption pattern of a positive spike form due to a considerable initial incoming current for a change from a stationary state to a rotation state.

As indicated by a reference numeral 509, the external device 102, such as an air conditioner, which gradually regulates an indoor temperature and humidity, has a power consumption pattern of a gradual falling form of power consumption.

As indicated by a reference numeral 510, a certain external device has the repetition of a power consumption pattern. For example, a refrigerator has no repetition of a power consumption pattern since it is used all day. However, a cooktop used for cooking may have the repetition of a power consumption pattern.

As discussed in FIG. 5, the external device 102 has a specific power pattern in power consumption due to internal components and operation characteristics defined in design. Contrary to a current pattern of a typical external device, such a power consumption pattern is uniform and not complicated. It is therefore to identify the external device 102 from a smaller number of power pattern information.

Additionally, the power information may further include information about at least one effective power range and information about a power factor as well as power pattern information. For example, since the external device 102 which performs a heating operation has a higher effective power range, the external device 102 which uses effective power greater than a given range may be considered as a device for heating. For example, since the external device 102 which has a resistive load has a higher power factor, the external device 102 from which a power factor greater than a given range is detected may be considered as a device having a resistive load.

The power pattern extracting unit 121 may extract a power consumption pattern of the external device 102 and then deliver it to a device identifying unit 124. The device identifying unit 124 may identify the type of the external device 102 by comparing the extracted power consumption pattern with power pattern information previously stored in the memory unit 150.

For example, if the external device 102 repeats power consumption in the positive spike form caused by a motor, in the flat form caused by load for a certain time, and in the small-scale vibration form, the electronic device 100 may determine the external device 102 as a vacuum cleaner which uses a small motor.

For example, if the external device 102 repeats power consumption in the negative spike form caused by a screen switch or channel change and in the small-scale vibration form caused by power consumption of a light source, the electronic device 100 may determine the external device 102 as a TV.

For example, if the external device 102 repeats power consumption in the flat form for heating for a certain time (e.g., at cooking) and in the pulse train form for maintaining a uniform temperature (e.g., at warming after cooking), the electronic device 100 may determine the external device 102 as an electric cooker.

The device identifying unit 124 may deliver information about the identified type of the external device 102 to the interface unit 130 or the communication unit 140.

A contextual unit 122 may collect contextual information by analyzing environments in which the external device 102 consumes electric power. This contextual information may be received from the other electronic device 200 through the communication unit 140 and then stored in the memory unit 150. The contextual information may include at least one of information about a usage time, information about an operating duration, information about a usage frequency, and information about weather (e.g., temperature, humidity).

For example, since the external device 102 such as an electric iron and a cooktop performs an operation for keeping a temperature, a power consumption pattern thereof may be similar to the pulse train form. Using such contextual information, it is possible to identify an electric iron and a cooktop.

In an embodiment, the contextual unit 122 may collect contextual information of the external device 102 by analyzing a power consuming circumstance of the external device 102 on the basis of information about a usage frequency.

Since an electric iron is used relatively less to iron clothes, the contextual unit 122 may collect contextual information indicating that the electric iron has a lower usage frequency for power consumption. Since a cooktop is used daily for cooking, the contextual unit 122 may collect contextual information indicating that the cooktop has a higher usage frequency for power consumption. Based on such contextual information collected using a usage frequency, the device identifying unit 124 may distinguish a cooktop from an electric iron. Although a cooktop and an electric iron have similar power consumption patterns, the device identifying unit 124 may recognize the external device 102 with a lower usage frequency as an electric iron and also recognize the external device 102 with a higher usage frequency as a cooktop.

In an embodiment, the contextual unit 122 may collect contextual information of the external device 102 by analyzing a power consuming circumstance of the external device 102 on the basis of information about a usage time.

Since an electric iron is used irregularly, the contextual unit 122 may collect contextual information indicating an irregular use. Since a cooktop is used mainly in the evening, the contextual unit 122 may collect contextual information indicating an evening use. Based on such contextual information collected using a usage time, the device identifying unit 124 may distinguish a cooktop from an electric iron. Although a cooktop and an electric iron have similar power consumption patterns, the device identifying unit 124 may recognize the external device 102 used mainly in the evening as a cooktop and also recognize the external device 102 used irregularly as an electric iron.

For example, a coffeepot and an electric heater may have a similar power consumption pattern of a flat form for heating. Using contextual information, it is possible to distinguish a coffeepot from an electric heater.

In an embodiment, the contextual unit 122 may collect contextual information by analyzing a power consuming circumstance of the external device 102 on the basis of information about an operating duration.

Normally a coffeepot operates within seven minutes, and an electric heater operates more than ten minutes. The contextual unit 122 may collect such an operating duration of the external device 102 as contextual information. For example, contextual information of a coffeepot may be collected as being used relatively for a short time. Contextual information of an electric heater may be collected as being used relatively for a long time. Based on such contextual information collected using an operating duration, the device identifying unit 124 may distinguish a coffeepot from an electric heater. Although a coffeepot and an electric heater have similar power consumption patterns, the device identifying unit 124 may recognize the external device 102 used for a short time as a coffeepot and also recognize the external device 102 used for a long time as an electric heater.

For example, the contextual unit 122 may collect contextual information of the external device 102 by analyzing a power consuming circumstance depending on weather. Since an air conditioner is used mainly during hot weather, the contextual unit 122 may collect, as contextual information, a temperature and humidity when the external device 102 is used. Using this collected contextual information regarding weather, the device identifying unit 124 may identify the external device 102.

A positioning unit 123 may collect location information by analyzing wireless signal strength information. When there is a plurality of electronic devices 100, the communication unit 140 may receive wireless signal strength information of an externally located electronic device 100. This received information is transmitted to the positioning unit 123. By receiving the wireless signal strength information from the communication unit 140, the positioning unit 123 may collect location information. The positioning unit 123 may transmit the collected location information to the device identifying unit 124. Based on the location information received from the positioning unit 123, the device identifying unit 124 may identify the type of the external device 102.

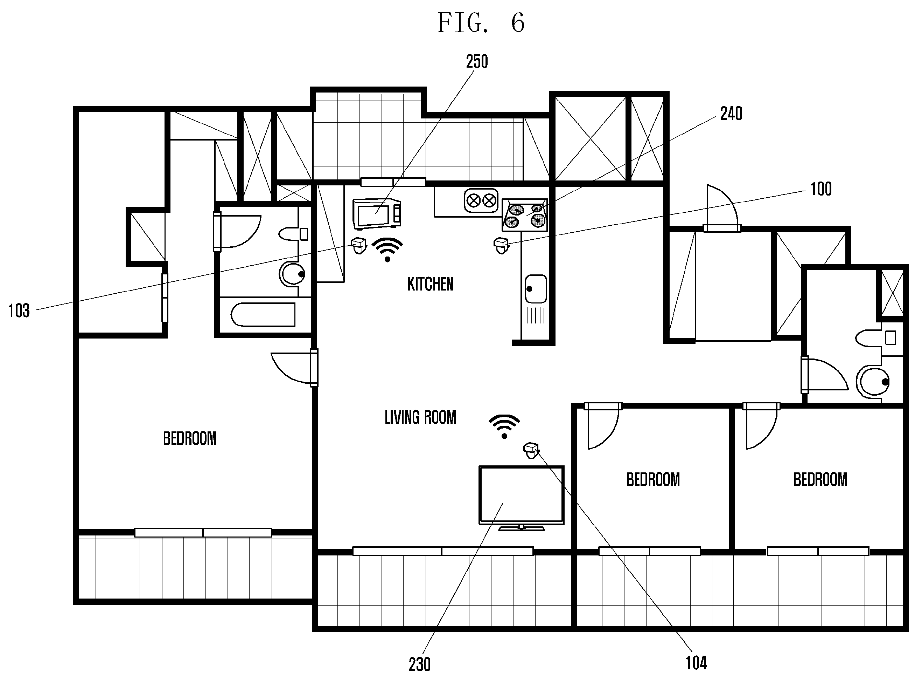

FIG. 6 is a diagram illustrating a method for detecting an external device 240 on the basis of location information according to an embodiment of the present invention. Referring to FIGS. 2 and 6, operations of the electronic device 100 according to an embodiment are as follows.

For example, when electronic devices 103 and 104 which have the same function and configuration as the electronic device 100 and are separated from the electronic device 100 are located in the living room and in the kitchen, respectively, a method for detecting the external device 240 at the electronic device 100 is as follows.

The electronic device 103 located in the kitchen may recognize a microwave oven 250 as an external device, and the electronic device 104 located in the living room may recognize a TV 230 as an external device. The electronic device 100 may receive at least one piece of wireless signal strength information from the electronic devices 103 and 104. Then the electronic device 100 may transmit the received wireless signal strength information to the positioning unit 123 of the electronic device 100. Using both the wireless signal information transmitted by the electronic device 103 located in the kitchen and the wireless signal information transmitted by the electronic device 104 located in the living room, the positioning unit 123 of the electronic device 100 may collect location information of the electronic device 100. For example, if the wireless signal information transmitted by the electronic device 103 located in the kitchen is greater than the wireless signal information transmitted by the electronic device 104 located in the living room, the positioning unit 123 of the electronic device 100 may collect location information indicating that the electronic device 103 located in the kitchen is nearer than the electronic device 104 located in the living room. The positioning unit 123 of the electronic device 100 may transmit the collected location information to the device identifying unit 124 of the electronic device 100. Using the collected location information, the device identifying unit 124 of the electronic device 100 may identify the external device 240 connected to the electronic device 100.

The electronic device 100 may receive, through the communication unit 140, information about the type of the external device identified by the electronic device 103 located near the electronic device 100 or near the other electronic device 200. If the electronic device 103 located near the electronic device 100 identifies a microwave oven 250 as an external device, the electronic device 100 may determine the external device 240 as being a device used in the kitchen or a similar type used in a similar location since the external device 240 connected to the electronic device 100 is located near the microwave oven 250. The device identifying unit 124 of the electronic device 100 may identify the external device connected to the electronic device 100 as a cooktop, based on the collected location information.

Based on at least one of power pattern information, contextual information, and location information, the device identifying unit 124 of the electronic device 100 may detect the external device connected to the electronic device 100.

The communication unit 140 may receive, from the other electronic device 200, a signal for controlling power supply of the external device 102. In an embodiment, using wired/wireless communication technologies, the communication unit 140 may transmit information about the type and power consumption of the external device 102 to the other electronic device 200 or receive a signal for controlling the power supply of the external device 102 from the other electronic device 200. Additionally, the communication unit 140 may include a network interface (e.g., LAN card) or a modem so as to connect the electronic device 100 to a network (e.g., internet, LAN (Local Area Network), WAN (Wide Area Network), telecommunication network, cellular network, satellite network, POTS (Plain Old Telephone Service), or the like). For example, the communication unit 140 may transmit or receive a wireless signal to or from at least one of a base station, an external device, and a server on the mobile communication network. The wireless signal may include a voice call signal, a video call signal, or various kinds of data associated with text/multimedia message transmission/reception. For example, the communication unit 140 may perform a function for wireless internet access. The wireless internet technique may use WLAN (Wireless LAN, Wi-Fi), Wibro (Wireless broadband), Wimax (World interoperability for microwave access), HSDPA (High Speed Downlink Packet Access), or the like. For example, the communication unit 140 may perform a function for short range communication. The short range communication technique may use Bluetooth, RFID (Radio Frequency IDentification), IrDA (Infrared Data Association), UWB (Ultra WideBand), ZigBee, or the like.

When there is the other electronic device 200 or a plurality of the electronic devices 100, the communication unit 140 may receive wireless signal strength information of the externally located electronic device 100. The communication unit 140 may the wireless signal strength information to the control unit 123.

The memory unit 150 may store at least one of power pattern information and contextual information received through the communication unit 140. The memory unit 150 may transmit the stored power pattern information and contextual information to the control unit 120.

The memory unit 150 may include at least one of an internal memory and an external memory.

The internal memory may include, for example, at least one of a volatile memory (e.g., DRAM (Dynamic RAM), SRAM (Static RAM), SDRAM (Synchronous Dynamic RAM), etc.), a nonvolatile memory (e.g., OTPROM (One Time Programmable ROM), PROM (Programmable ROM), EPROM (Erasable and Programmable ROM), EEPROM (Electrically Erasable and Programmable ROM), mask ROM, flash ROM, etc.), HDD (Hard Disk Drive), and SSD (Solid State Drive). According to an embodiment, the control unit 120 may load commands or data, received from at least one of the nonvolatile memory and other elements, on the volatile memory and process them. Additionally, the control unit 120 may retain data, created or received from other element, in the nonvolatile memory. The external memory may include at least one of CF (Compact Flash), SD (Secure Digital), Micro-SD (Micro Secure Digital), Mini-SD (Mini Secure Digital), xD (extreme Digital), and a memory stick. The memory unit 150 may store an operating system for controlling resources of the electronic device 100 and programs for the operation of applications. The operating system may include kernel, middleware, API, and the like.

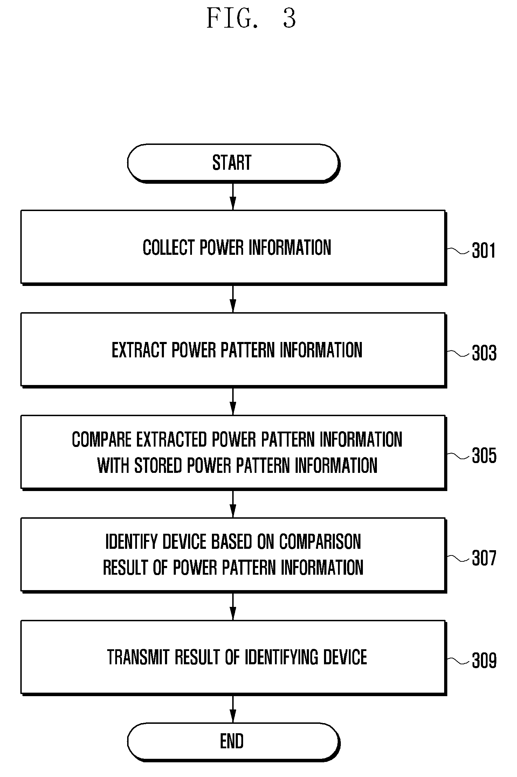

FIG. 3 is a flow diagram illustrating an external device detection method of an electronic device 100 according to an embodiment of the present invention.

At step 301, the electronic device 100 may collect power information of an external device connected to the electronic device 100. At step 301, the electronic device 100 may monitor variations in power of the external device through the current-voltage measuring unit 110 and thereby collect power information of the external device.

At step 303, the electronic device 100 may extract power pattern information from the collected power information of the external device. At step 303, the electronic device 100 may extract a power pattern of the external device by using power information of the external device delivered from the current-voltage measuring unit 110 through the power pattern extracting unit 121. The external device may have a specific power pattern in power consumption due to internal components and operation characteristics defined in design thereof. The electronic device 100 may collect a specific power pattern of the external device and then extract pattern information therefrom.

Referring to FIGS. 2, 3 and 5, a process in which the electronic device 100 extracts, at step 303, power pattern information from the collected power information of the external device is as follows.

As indicated by a reference numeral 501, the external device such as a microwave oven has a power consumption pattern of a 2-stage turn-on type from low power consumption to high power consumption so as to uniformly apply heat to food, for example, so as to heat food after thaw. Specifically, the power consumption pattern of a 2-stage turn-on type includes an increase of effective power in the off-state, a flat form for a certain time, a further increase of effective power, and a further flat form.

As indicated by a reference numeral 502, the external device, such as a coffeepot or a toaster, which cooks food or heats liquid for a short time, the external device, such as an electric heater, which provides heat for a certain time, or the external device, such as a vacuum cleaner, which has load for a certain time, has a power consumption pattern of a flat form for a certain time.

As indicated by a reference numeral 503, the external device, such as a refrigerator or a vacuum cleaner, which uses a small motor, or the external device, such as a TV, which uses a light source, has a power consumption pattern of a small-scale vibration form.

As indicated by a reference numeral 504, the external device, such as a TV, which performs a screen switch or channel change, has a power consumption pattern of a negative spike form in which effective power consumption is reduced only for a short time at the screen switch or channel change.

As indicated by a reference numeral 505, the external device, such as an air conditioner, which gradually regulates an indoor temperature and humidity, has a power consumption pattern of a gradual rising form of power consumption.

As indicated by a reference numeral 506, the external device, such as an electric iron or a cooktop, which should maintain a uniform temperature without overheating, has a power consumption pattern of a pulse train form.

As indicated by a reference numeral 507, the external device, such as a washing machine, which uses a large motor and causes an increase or reduction in power consumption depending on inertia of laundry, has a power consumption pattern of a large-scale vibration form.

As indicated by a reference numeral 508, the external device which uses a motor has a power consumption pattern of a positive spike form due to a considerable initial incoming current for a change from a stationary state to a rotation state.

As indicated by a reference numeral 509, the external device, such as an air conditioner, which gradually regulates an indoor temperature and humidity, has a power consumption pattern of a gradual falling form of power consumption.

As indicated by a reference numeral 510, a certain external device has the repetition of a power consumption pattern. For example, a refrigerator has no repetition of a power consumption pattern since it is used all day. However, a cooktop used for cooking may have the repetition of a power consumption pattern.

The external device has a specific power pattern in power consumption due to internal components and operation characteristics defined in design. Contrary to a current pattern of a typical external device, such a power consumption pattern is uniform and not complicated. It is therefore to identify the external device from a smaller number of power pattern information.

Additionally, the power information may further include information about at least one effective power range and information about a power factor as well as power pattern information. For example, since the external device which performs a heating operation has a higher effective power range, the external device which uses effective power greater than a given range may be considered as a device for heating. For example, since the external device which has a resistive load has a higher power factor, the external device from which a power factor greater than a given range is detected may be considered as a device having a resistive load.

At step 305, the electronic device 100 may compare the extracted power pattern information with previously stored power pattern information. At step 305, the electronic device 100 may create comparison information by comparing the power pattern information extracted at the power pattern extracting unit 121 with the power pattern information stored in the memory unit 150.

At step 307, the electronic device 100 may identify the external device, based on the comparison information obtained by comparing the extracted power pattern information with the stored power pattern information. At step 307, the electronic device 100 may identify, through the device identifying unit 124, the type of the external device 102 by comparing the extracted power consumption pattern information with the power pattern information stored in the memory unit 150.

For example, if the external device repeats power consumption in the positive spike form caused by a motor, in the flat form caused by load for a certain time, and in the small-scale vibration form, the electronic device 100 may determine, at step 307, the external device as a vacuum cleaner which uses a small motor.

For example, if the external device repeats power consumption in the negative spike form caused by a screen switch or channel change and in the small-scale vibration form caused by power consumption of a light source, the electronic device 100 may determine, at step 307, the external device as a TV.

For example, if the external device 102 repeats power consumption in the flat form for heating for a certain time (e.g., at cooking) and in the pulse train form for maintaining a uniform temperature (e.g., at warming after cooking), the electronic device 100 may determine, at step 307, the external device as an electric cooker.

At step 309, the electronic device 100 may transmit a result of identifying the external device. At step 309, the electronic device 100 may deliver information about the type of the identified external device 102 to the interface unit 130 or the communication unit 140. At step 309, the electronic device 100 may transmit information about the type of the identified external device to the other electronic device 200 such as an energy management device. At step 309, the electronic device 100 may deliver information about the type of the identified external device 120 to one or more electronic devices 103 and 104 which are the same as the electronic device 100 and separated from the electronic device 100.

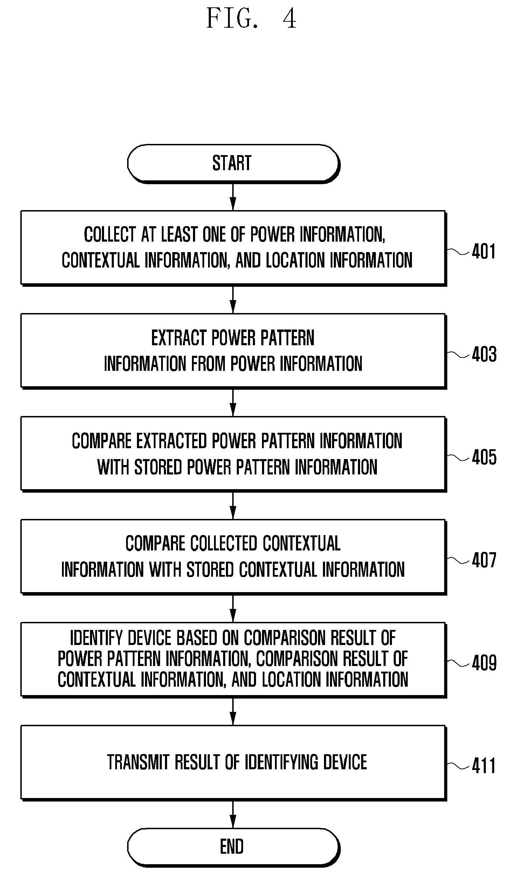

FIG. 4 is a flow diagram illustrating an external device detection method of an electronic device 100 according to an embodiment of the present invention.

At step 401, the electronic device 100 may collect power information, contextual information, and location information regarding at least one external device connected to the electronic device 100.

At step 401, the electronic device 100 may monitor, through the current-voltage measuring unit 110, variations in power of the external device connected to the electronic device 100 and thereby collect power information of the external device.

At step 401, the electronic device 100 may collect, through the contextual unit 122, contextual information by analyzing environments in which the external device 102 consumes electric power. This contextual information may be received from the other electronic device 200 through the communication unit 140 and then stored in the memory unit 150. The contextual information may include at least one of information about a usage time, information about an operating duration, information about a usage frequency, and information about weather (e.g., temperature, humidity).

At step 401, the electronic device 100 may collect, through the positioning unit 123, location information by analyzing wireless signal strength information. When there is a plurality of electronic devices 100, the communication unit 140 may receive wireless signal strength information of the electronic device 100 located externally. This received information is transmitted to the positioning unit 123. At step 401, the electronic device 100 may collect location information by receiving the wireless signal strength information from the communication unit 140.

At step 403, the electronic device 100 may extract power pattern information from the collected power information of the external device. At step 403, the electronic device 100 may extract power pattern of the external device by using power information about the external device delivered from the current-voltage measuring unit 110 through the power pattern extracting unit 121. The external device may have a specific power pattern in power consumption due to internal components and operation characteristics defined in design.

Referring to FIGS. 2, 4 and 5, a process in which the electronic device 100 extracts, at step 403, power pattern information from the collected power information of the external device is as follows.

As indicated by a reference numeral 501, the external device such as a microwave oven has a power consumption pattern of a 2-stage turn-on type from low power consumption to high power consumption so as to uniformly apply heat to food, for example, so as to heat food after thaw. Specifically, the power consumption pattern of a 2-stage turn-on type includes an increase of effective power in the off-state, a flat form for a certain time, a further increase of effective power, and a further flat form.

As indicated by a reference numeral 502, the external device, such as a coffeepot or a toaster, which cooks food or heats liquid for a short time, the external device, such as an electric heater, which provides heat for a certain time, or the external device, such as a vacuum cleaner, which has load for a certain time, has a power consumption pattern of a flat form for a certain time.

As indicated by a reference numeral 503, the external device, such as a refrigerator or a vacuum cleaner, which uses a small motor, or the external device, such as a TV, which uses a light source, has a power consumption pattern of a small-scale vibration form.

As indicated by a reference numeral 504, the external device, such as a TV, which performs a screen switch or channel change, has a power consumption pattern of a negative spike form in which effective power consumption is reduced only for a short time at the screen switch or channel change.

As indicated by a reference numeral 505, the external device, such as an air conditioner, which gradually regulates an indoor temperature and humidity, has a power consumption pattern of a gradual rising form of power consumption.

As indicated by a reference numeral 506, the external device, such as an electric iron or a cooktop, which should maintain a uniform temperature without overheating, has a power consumption pattern of a pulse train form.

As indicated by a reference numeral 507, the external device, such as a washing machine, which uses a large motor and causes an increase or reduction in power consumption depending on inertia of laundry, has a power consumption pattern of a large-scale vibration form.

As indicated by a reference numeral 508, the external device which uses a motor has a power consumption pattern of a positive spike form due to a considerable initial incoming current for a change from a stationary state to a rotation state.

As indicated by a reference numeral 509, the external device, such as an air conditioner, which gradually regulates an indoor temperature and humidity, has a power consumption pattern of a gradual falling form of power consumption.

As indicated by a reference numeral 510, a certain external device has the repetition of a power consumption pattern. For example, a refrigerator has no repetition of a power consumption pattern since it is used all day. However, a cooktop used for cooking may have the repetition of a power consumption pattern.

The external device has a specific power pattern in power consumption due to internal components and operation characteristics defined in design. Contrary to a current pattern of a typical external device, such a power consumption pattern is uniform and not complicated. It is therefore to identify the external device from a smaller number of power pattern information.

Additionally, the power information may further include information about at least one effective power range and information about a power factor as well as power pattern information. For example, since the external device which performs a heating operation has a higher effective power range, the external device which uses effective power greater than a given range may be considered as a device for heating. For example, since the external device which has a resistive load has a higher power factor, the external device from which a power factor greater than a given range is detected may be considered as a device having a resistive load.

At step 405, the electronic device 100 may compare the extracted power pattern information with previously stored power pattern information. At step 405, the electronic device 100 may create comparison information by comparing the power pattern information extracted at the power pattern extracting unit 121 with the power pattern information stored in the memory unit 150.

At step 407, the electronic device 100 may compare the collected contextual information with previously stored contextual information. At step 407, the electronic device 100 may create comparison information by comparing the collected contextual information with the contextual information stored in the memory unit 150.

At step 409, the electronic device 100 may identify the external device, based on at least one of the comparison information of power pattern information, the comparison information of contextual information, and the collected location information.

For example, since the external device such as an electric iron and a cooktop performs an operation for keeping a temperature, a power consumption pattern thereof may be similar to the pulse train form.

Since an electric iron is used relatively less to iron clothes, the electronic device 100 may collect contextual information indicating that the electric iron has a lower usage frequency for power consumption. Since a cooktop is used daily for cooking, the electronic device 100 may collect contextual information indicating that the cooktop has a higher usage frequency for power consumption. Based on such contextual information collected using a usage frequency, the electronic device 100 may distinguish a cooktop from an electric iron at step 409. Although it is determined that a cooktop and an electric iron have similar power consumption patterns, the electronic device 100 may recognize the external device with a lower usage frequency as an electric iron and also recognize the external device with a higher usage frequency as a cooktop by comparing the collected contextual information with the stored contextual information based on a usage frequency.

Additionally, since an electric iron is used irregularly, the electronic device 100 may collect contextual information indicating an irregular use. Since a cooktop is used mainly in the evening, the electronic device 100 may collect contextual information indicating an evening use. At step 409, the electronic device 100 may distinguish a cooktop from an electric iron, based on a result of comparing contextual information collected using a usage time with the stored contextual information. At step 409, although it is determined that a cooktop and an electric iron have similar power consumption patterns, the electronic device 100 may recognize the external device used mainly in the evening as a cooktop and also recognize the external device used irregularly as an electric iron by comparing the collected contextual information with the stored contextual information based on a usage time.

For example, a coffeepot and an electric heater may have a similar power consumption pattern of a flat form for heating.

Normally a coffeepot operates within seven minutes, and an electric heater operates more than ten minutes. The electronic device 100 may collect such an operating duration of the external device as contextual information. For example, contextual information of a coffeepot may be collected as being used relatively for a short time. Contextual information of an electric heater may be collected as being used relatively for a long time. At step 409, the electronic device 100 may distinguish a coffeepot from an electric heater, based on a result of comparing the contextual information collected using an operating duration with the stored contextual information. At step 409, although it is determined that a coffeepot and an electric heater have similar power consumption patterns, the electronic device 100 may recognize the external device used for a short time as a coffeepot and also recognize the external device used for a long time as an electric heater by comparing the collected contextual information with the stored contextual information based on an operating duration.

For example, the electronic device 100 may collect contextual information of the external device by analyzing a power consuming circumstance depending on weather. Since an air conditioner is used mainly during hot weather, the electronic device 100 may collect, as contextual information at step 409, a temperature and humidity when the external device is used. Using this collected contextual information regarding weather, the electronic device 100 may identify the external device at step 409.

Referring to FIGS. 2, 4 and 6, a process in which the electronic device 100 identifies, at step 409, the external device, based on at least one of the comparison information of power pattern information, the comparison information of contextual information, and the collected location information is as follows.

For example, when electronic devices 103 and 104 which have the same as the electronic device 100 and are separated from the electronic device 100 are located in the living room and in the kitchen, respectively, a method for detecting the external device 240 at the electronic device 100 is as follows.

The electronic device 103 located in the kitchen may recognize a microwave oven 250 as an external device, and the electronic device 104 located in the living room may recognize a TV 230 as an external device. The electronic device 100 may receive at least one piece of wireless signal strength information from the electronic devices 103 and 104. Then the electronic device 100 may transmit the received wireless signal strength information to the electronic device 100. Using both the wireless signal information transmitted by the electronic device 103 located in the kitchen and the wireless signal information transmitted by the electronic device 104 located in the living room, the electronic device 100 may collect location information of the electronic device 100. For example, if the wireless signal information transmitted by the electronic device 103 located in the kitchen is greater than the wireless signal information transmitted by the electronic device 104 located in the living room, the electronic device 100 may collect location information indicating that the electronic device 103 located in the kitchen is nearer than the electronic device 104 located in the living room. At step 409, the electronic device 100 may identify the external device 240 connected to the electronic device 100 by using the collected location information.

If the electronic device 103 located near the electronic device 100 identifies a microwave oven 250 as an external device, the electronic device 100 may determine the external device 240 as being a device used in the kitchen or a similar type used in a similar location since the external device 240 connected to the electronic device 100 is located near the microwave oven 250. At step 409, the electronic device 100 may identify the external device connected to the electronic device 100 as a cooktop, based on the collected location information.

At step 411, the electronic device 100 may transmit a result of identifying the external device. At step 411, the electronic device 100 may deliver information about the type of the identified external device to the interface unit 130 or the communication unit 140. At step 411, the electronic device 100 may transmit information about the type of the identified external device to the other electronic device 200 such as an energy management device. At step 411, the electronic device 100 may deliver information about the type of the identified external device 120 to one or more electronic devices 103 and 104 which are the same as the electronic device 100 and separated from the electronic device 100.

While this invention has been particularly shown and described with reference to an exemplary embodiment thereof, it will be understood by those skilled in the art that various changes in form and details may be made therein without departing from the spirit and scope of this invention as defined by the appended claims.

## Claims

1. A method for detecting an external device at an electronic device connected to the external device, the method comprising steps of:
collecting power information of the external device;
extracting power pattern information from the collected power information;
comparing the extracted power pattern information with previously stored power pattern information; and
identifying a type of the external device, based on a comparison result.

2. The method of claim 1, wherein the step of collecting the power information of the external device includes collecting information about at least one of a power pattern, effective power, and a power factor while the external device consumes electric power.

3. The method of claim 1, further comprising step of:
transmitting a result of identifying the external device and information about power consumption of the external device to other electronic device.

4. A method for detecting an external device at an electronic device connected to the external device, the method comprising steps of:
collecting power information, contextual information, and location information about at least one of the external device;
extracting power pattern information from the collected power information;
comparing the extracted power pattern information with previously stored power pattern information;
comparing the collected contextual information with previously stored contextual information; and
identifying a type of the external device, based on a comparison result of the power pattern information, a comparison result of the contextual information, and the location information.

5. The method of claim 4, wherein the power information includes information about at least one of a power pattern, effective power, and a power factor while the external device consumes electric power.

6. The method of claim 4, wherein the contextual information includes at least one of information about a usage time of the external device, information about an operating duration of the external device, information about a usage frequency of the external device, and information about weather at time of using the external device.

7. The method of claim 4, wherein the location information is created by analyzing strength of a wireless signal received from at least one electronic device having the same function as the electronic device.

8. The method of claim 4, further comprising:
transmitting a result of identifying the external device and information about power consumption of the external device to other electronic device.

9. An electronic device connected to an external device, the electronic device comprising:
a communication unit connected to other electronic device by means of communication;
a current-voltage measuring unit configured to collect power information of the external device; and
a control unit configured to extract power pattern information from the collected power information, to compare the extracted power pattern information with previously stored power pattern information, and to identify a type of the external device, based on a comparison result.

10. The electronic device of claim 9, wherein the control unit is further configured to collect power information, contextual information, and location information about at least one of the external device, to compare the collected contextual information with previously stored contextual information, and to identify the type of the external device, based on a comparison result of the contextual information and the location information.

11. The electronic device of claim 10, wherein the power information includes information about at least one of a power pattern, effective power, and a power factor while the external device consumes electric power.

12. The electronic device of claim 10, wherein the contextual information includes at least one of information about a usage time of the external device, information about an operating duration of the external device, information about a usage frequency of the external device, and information about weather at time of using the external device.

13. The electronic device of claim 10, wherein the location information is created by analyzing strength of a wireless signal received from at least one electronic device having the same function as the electronic device.

14. The electronic device of claim 10, wherein the control unit is further configured to transmit a result of identifying the external device and information about power consumption of the external device to other electronic device through the communication unit.
